(19) Europäisches Patentamt
European Patent Office
Office européen des brevets

(11) Veröffentlichungsnummer : **0 031 593**
**B1**

(12) **EUROPÄISCHE PATENTSCHRIFT**

(45) Veröffentlichungstag der Patentschrift : **25.07.84**

(51) Int. Cl.³ : **G 03 C 1/68**, G 03 C 1/71, G 03 C 1/727, G 03 F 7/00, G 03 F 7/10, C 08 L 33/06

(21) Anmeldenummer : **80108191.0**

(22) Anmeldetag : **24.12.80**

(54) **Durch Strahlung polymerisierbares Gemisch und damit hergestelltes strahlungsempfindliches Kopiermaterial.**

(30) Priorität : **29.12.79 DE 2952697**

(43) Veröffentlichungstag der Anmeldung : **08.07.81 Patentblatt 81/27**

(45) Bekanntmachung des Hinweises auf die Patenterteilung : **25.07.84 Patentblatt 84/30**

(84) Benannte Vertragsstaaten : **BE CH DE FR GB IT LI NL SE**

(56) Entgegenhaltungen : **DE-A- 2 628 562**

(73) Patentinhaber : **HOECHST AKTIENGESELLSCHAFT**
**Postfach 80 03 20**
**D-6230 Frankfurt am Main 80 (DE)**

(72) Erfinder : **Sander, Jürgen, Dr., Chem.**
**Berliner Ring 27**
**D-6233 Kelkheim/Ts. (DE)**
Erfinder : **Horn, Klaus, Dr., Dipl.-Chem.**
**Lessingstrasse 53**
**D-6238 Hofheim/Ts. (DE)**

**EP 0 031 593 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft ein durch Strahlung polymerisierbares, insbesondere ein photopolymerisierbares Gemisch, das als wesentliche Bestandteile (a) eine radikalisch polymerisierbare Verbindung mit endständigen äthylenisch ungesättigten Gruppen, (b) ein polymeres Bindemittel und (c) einen durch Strahlung aktivierbaren Initiator enthält.

Derartige polymerisierbare Gemische sind z. B. aus den US-Patentschriften 2 760 863, 3 060 023 und 3 149 975 bekannt. Als polymerisierbare äthylenisch ungesättigte Verbindungen werden dort niedermolekulare und hochmolekulare Verbindungen mit endständigen bzw. seitenständigen Vinyl- oder Vinylidengruppen, insbesondere Acryl- und Methacrylsäureester von niedermolekularen oder hochmolekularen Polyhydroxyverbindungen, beschrieben. In der Praxis haben sich bisher fast ausschließlich photopolymerisierbare Materialien auf der Basis solcher Ester als polymerisierbare Verbindungen durchgesetzt. Von diesen sind es insbesondere die niedermolekularen Vertreter, die in der Technik bevorzugt eingesetzt werden.

Aus der DE-A 26 28 562 sind photopolymerisierbare Materialien bekannt, die Acryl- bzw. Methacrylsäure-ester von Diolen enthalten, die in ihrer Kette noch Esterbindungen aufweisen.

Obwohl diese Verbindungen Gemische mit hoher praktischer Lichtempfindlichkeit und Belichtungsprodukte mit hoher Vernetzungsdichte ergeben, wäre es in manchen Fällen wünschenswert, Verbindungen mit anderen Eigenschaften, z. B. mit geringerer Flüchtigkeit und Klebrigkeit oder auch höherer Beständigkeit gegen verseifende Agenzien, zur Verfügung zu haben.

Aus der DE-A-25 56 845 sind photopolymerisierbare Gemische bekannt, die als polymerisierbare Verbindungen ungesättigte Polyester von Dicarbonsäuren enthalten, die eine α-ständige Methylengruppe aufweisen. Diese Verbindungen haben viele erwünschte mechanische und chemische Eigenschaften. Die Lichtempfindlichkeit der damit hergestellten Gemische erreicht aber nicht die der bevorzugten Acrylsäureester.

Aufgabe der Erfindung ist es, durch Strahlung polymerisierbare Gemische vorzuschlagen, die in ihrer Strahlungsempfindlichkeit den bekannten Gemischen auf Basis von Acrylestern mindestens vergleichbar sind, aber keine flüchtigen polymerisierbaren Verbindungen enthalten, keine klebrigen oder zur Kristallisation neigenden Schichten ergeben und deren Lichtvernetzungsprodukte eine hohe Beständigkeit gegen aggressive, z. B. verseifende Agenzien aufweisen.

Gegenstand der Erfindung ist ein durch Strahlung polymerisierbares Gemisch, das

a) eine radikalisch polymerisierbare Verbindung mit endständigen äthylenisch ungesättigten Gruppen,

b) ein vorzugsweise gesättigtes polymeres Bindemittel und

c) einen durch Strahlung aktivierbaren Polymerisationsinitiator

enthält.

Das erfindungsgemäße Gemisch ist dadurch gekennzeichnet, daß es als polymerisierbare Verbindung eine Verbindung der Formel I

$$A-\overset{\overset{CH_2}{\|}}{C}-R_1-\overset{\overset{CH_2}{\|}}{C}-A \qquad (I)$$

enthält, in der

$R_1$ eine Alkylengruppe mit 1 bis 15 Kohlenstoffatomen, die auch teilweise durch Heteroatome ersetzt sein können, eine Cycloalkylengruppe mit 3 bis 15 Kohlenstoffatomen, oder eine gemischt aliphatischaromatische Gruppe mit 7 bis 15 Kohlenstoffatomen und

A ein elektronenanziehender Rest ist.

Der elektronenanziehende Rest A ist vorzugsweise ein über ein Kohlenstoff- oder Stickstoffatom gebundener Rest, in dem dieses Atom an mindestens ein Sauerstoff-, Stickstoff- oder Schwefelatom gebunden ist.

Wenn der Rest A über ein Kohlenstoffatom an die ungesättigten Einheiten gebunden ist, hat das Kohlenstoffatom die Heterofunktionalität zwei oder drei. Das bedeutet, daß das Kohlenstoffatom mit seinen freien Valenzen Bindungen zu einem, zwei oder drei Heteroatomen in Form von Einfach-, Doppel- oder Dreifachbindungen ausbilden kann.

Beispiele für elektronenziehende Reste A sind Nitro-, Äthylsulfonyl-, Phenylsulfonyl-, Methylsulfonyl-, Methylsulfinyl-, Methoxysulfinyl-, Dimethoxyphosphinyl-, Methylmethoxyphosphinyl-, Dimethylphosphinyl-, Nitril-, Carbonsäureester-, Carbonsäure-, Keto- und Aldehydgruppen sowie insbesondere solche Gruppen, die leicht zugänglichen Keton- oder Säurederivaten entsprechen, vorzugsweise Aldehyd-, Keto-, Azomethin-, Oxim-, Hydrazon-, Thioaldehyd-, Thioketon-, Säure-, Ester-, Anhydrid-, Amid-, Imid-, Säureazid-, Thioester-, Thionester-, Dithioester-, Imidoester-, Amidin- und Imidothioester-Gruppen.

Eine besondere Gruppe von Verbindungen der allgemeinen Formel I stellen Verbindungen der Formel II dar.

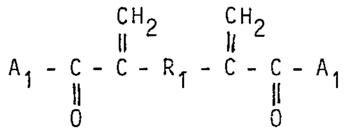

(II)

Dabei hat $R_1$ die oben angegebene Bedeutung.

$A_1$ ist ein Wasserstoffatom, eine Hydroxy- oder Aminogruppe, ein Alkyl-, Aryl-, Alkoxy-, Aryloxy-, Alkylamino-, Arylamino-, Alkylthio-, Arylthio-, Acyloxy-, Acylamino-, Sulfonyloxy- oder Sulfonylaminorest.

Die Verbindungen der Formel II sollen Aldehyde, Ketone und Säuren sowie deren einfach herzustellende Derivate umfassen.

Eine bevorzugte Gruppe von Verbindüngen der Formel II sind, neben den Dicarbonsäuren, die Ester der Formel III

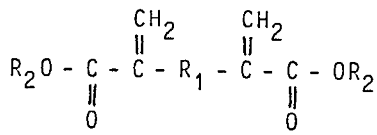

(III)

Dabei hat $R_1$ die oben angegebene Bedeutung.

$R_2$ ist ein Alkyl- oder Alkenylrest mit 1 bis 15 C-Atomen, die auch teilweise durch Heteroatome, wie O, S, N, insbesondere O, ersetzt sein können, ein Cycloalkylrest mit 3 bis 15 Kohlenstoffatomen oder ein Aralkylrest mit 7 bis 15 Kohlenstoffatomen, vorzugsweise ein Alkylrest mit 1 bis 4 C-Atomen, besonders bevorzugt der Methyl- oder Äthylrest.

Als Gruppen $R_1$ kommen beispielsweise in Frage Methylen-, Äthylen-1,2-, Propylen-1,3-, 2-Oxa-propylen-1,3-, 2,2-Dimethyl-propylen-1,3-, 2,2-Diäthyl-propylen-1,3-, Butylen-1,4-, Pentylen-1,5-, Hexylen-1,6-, 2-Äthyl-hexylen-1,6-, 2,3-Dimethyl-hexylen-1,6-, Heptylen-1,7-, Octylen-1,8-, Nonylen-1,9-, 3,6-Dimethyl-nonylen-1,9-, Decylen-1,10-, Dodecylen-1,12-, Cyclohexylen-1,4-bismethylen, But-2-en-ylen-1,4-, o-, m- und p-Xylylen-, 3-Thia-pentylen-1,5-, 3-Oxa-pentylen-1,5-, 3,6-Dioxa-octylen-1,8-, 3,6,9-Trioxa-undecylen-1,11-, 3,6,9,12-Tetraoxa-tetradecylen-1,14- und 4-Oxa-heptylen-1,7-Gruppen.

Geeignete Alkylreste $R_2$ sind z. B. Methyl-, Äthyl-, Propyl-, Allyl-, Butyl-, Pentyl-, Hexyl-, Heptyl-, Octyl, Nonyl-, Decyl-, Undecyl-, Dodecyl-, 2-Phenoxy-äthyl-, 2-Oxa-5-methoxy-pentyl-, 2-Brom-äthyl-, 2-Methoxy-äthyl-, 2-Phenyl-äthyl-, 2-Oxa-5-äthoxy-pentyl-, 2-Oxa-5-butyloxy-pentyl-, 2-Äthyl-butyl- und 2-Methylbutylreste.

Die Herstellung der polymerisierbaren Verbindungen I gelingt z. B. durch direkte Kondensation leicht zugänglicher Verbindungen IV mit Formaldehyd,

$$A—CH_2—R_1—CH_2—A \qquad (IV)$$

wenn es sich bei den elektronenanziehenden Gruppen A z. B. um Aldehyd-, Keto- oder Nitrogruppen handelt. Die Kondensationsreaktion wird. i. a. erleichtert oder sogar erst ermöglicht, wenn die Verbindungen IV zusätzlich aktiviert sind ; insbesondere die Aktivierung mit Hilfe von Carboxylgruppen in Form der Verbindungen V

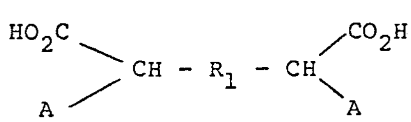

(V)

hat sich bewährt, da die Umsetzung der Dicarbonsäuren V mit Formaldehyd bei sehr schonenden Reaktionsbedingungen unter Decarboxylierung zu den Verbindungen I führt.

Da diese Verbindungen V z. B. durch doppelte Alkylierung methylenaktiver Verbindungen $A—CH_2—CO_2—$Alkyl mit Dibromverbindungen $Br—R_1—Br$ und anschließende Verseifung der entstandenen Bisalkylierungsprodukte VI

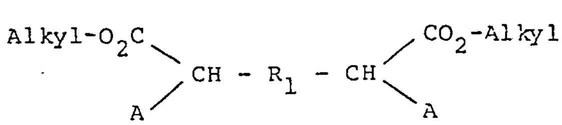

(VI)

leicht herstellbar sind, besteht ein einfacher Zugang zu den polymerisierbaren Verbindungen I.

Neben der Variation des Alkylenrestes $R_1$ durch den Einsatz unterschiedlicher Bishalogen-, insbesondere Dibromverbindungen, z. B. von

1,2-Dibrom-äthan,
1,3-Dibrom-propan,
2,2-Dimethyl-1,3-dibrom-propan,
1,4-Dibrom-butan,
1,5-Dibrom-pentan,
1,6-Dibrom-hexan,
2,3-Dimethyl-1,6-dibrom-hexan,
1,7-Dibrom-heptan,
1,8-Dibrom-octan,
1,9-Dibrom-nonan,
3,6-Dimethyl-1,9-dibrom-nonan,
1,10-Dibrom-decan,
1,12-Dibrom-dodecan,
1,4-Bis-(brommethyl)-cyclohexan,
o-, m- und p-Xylylendichlorid,
3-Thia-1,5-dibrom-pentan,
3-Methyl-1,5-dibrom-pentan,
3-Oxa-1,5-dibrom-pentan,
3,6-Dioxa-1,8-dibrom-octan,
3,6,9-Trioxa-1,11-dibrom-undecan,
3,6,9,12-Tetraoxa-1,14-dibrom-tetradecan und
4-Oxa-1,7-dibrom-heptan

ist auch die Variation der elektronenanziehenden Gruppe A durch die Auswahl verschiedener methylenaktiver Verbindungen, insbesondere der Methyl- oder Äthylester der Malonsäure und Cyanessigsäure möglich.

Bei Einsatz dieser methylenaktiven Verbindungen ist sowohl eine leichte Umwandlung zu den Verbindungen VI als auch eine leichte weitere Umsetzung der Nitril- bzw. Esterfunktion gewährleistet. So kann man z. B. Nitrile und Ester leicht zu Säuren verseifen. Bei Säuren wiederum ist u. a. die Umwandlung in Nitrile und Ketone möglich.

Als Derivate von Aldehyden und Ketonen lassen sich z. B. Oxime und Hydrazone leicht herstellen, während Säuren sich leicht mit aliphatischen Hydroxyverbindungen, aktivierten Isocyanaten und Isothiocyanaten und aktivierten Chlorverbindungen, z. B. Säurechloriden, umsetzen lassen.

Die aus den Dicarbonsäuren der Formel II leicht erhältlichen Bis-Säurechloride wiederum reagieren z. B. mit Ammoniak, aliphatischen und aromatischen Aminen, aromatischen Hydroxyverbindungen, aliphatischen und aromatischen Thioverbindungen, Säuren, Amiden und metallorganischen Verbindungen.

Beispiele für die genannten Reaktionspartner der Dicarbonsäuren II und ihrer Bis-Säurechloride sind : Propanol, Allylalkohol, Butanol, Pentanol, Hexanol, Heptanol, Octanol, Nonanol, Decanol, Undecanol, Dodecanol, Bromäthanol, Äthylenglykolmonomethyläter, Äthylenglykolmonophenyläther, 2-Phenyläthanol, Diäthylenglykolmonomethyläther, Hydroxymethylcyclohexan, Äthoxycarbonylisocyanat, Benzoylisocyanat, Benzoylisothiocyanat, Vinylsulfonylisocyanat, Acetylchlorid, Benzoylchlorid, Acrylsäurechlorid, Methacrylsäurechlorid, Chlorameisensäureäthylester, Dimethylcarbaminsäurechlorid, Ammoniak, Methylamin, Dimethylamin, Äthylamin, Diäthylamin, Anilin, N-Methylanilin, Phenol, Naphthol, p-Methoxyphenol, Cumylphenol, p-Phenoxyphenol, Äthylmercaptan, Thiophenol, Acetamid, Benzamid, Acrylsäureamid und Methacrylsäureamid.

Die so hergestellten polymerisierbaren Verbindungen I, von denen einige in der Literatur beschrieben sind, z. B. in

Journal of American Chemical Society 79, 5771 (1957)
Journal of American Chemical Society 81, 984 (1959)
Synthesis 29 (1979)
Journal of Macromolecular Science, Chem. A5, 181 (1971)
Comptes Rendues 2237 (13.11.1961) und
Journal für praktische Chemie 313, 205 (1971)

lassen sich im allgemeinen nach Destillation oder Kristallisation reproduzierbar in einheitlicher Form isolieren.

Durch Verwendung der Polymerisierbaren Verbindungen der Formel I bzw. von deren Gemischen lassen sich die stofflichen Eigenschaften der damit hergestellten Aufzeichnungsmaterialien breit variieren.

Geeignete Verbindungen I sind z. B. Alkylester der folgenden Säuren, die sich durch den Alkylenrest $R_1$ unterscheiden :

Hexa-1,5-dien-2,5-dicarbonsäure
Hepta-1,6-dien-2,6-dicarbonsäure
4-Oxa-hepta-1,6-dien-2,6-dicarbonsäure

4,4-Dimethyl-hepta-1,6-dien-2,6-dicarbonsäure
4,4-Diäthyl-hepta-1,6-dien-2,6-dicarbonsäure
Octa-1,7-dien-2,7-dicarbonsäure
Nona-1,8-dien-2,8-dicarbonsäure
Deca-1,9-dien-2,9-dicarbonsäure
Undeca-1,10-dien-2,10-dicarbonsäure
Dodeca-1,11-dien-2,11-dicarbonsäure
Trideca-1,12-dien-2,12-dicarbonsäure
Tetradeca-1,13-dien-2,13-dicarbonsäure
Hexadeca-1,15-dien-2,15-dicarbonsäure
5-Oxa-nona-1,8-dien-2,8-dicarbonsäure
5-Thia-nona-1,8-dien-2,8-dicarbonsäure
Octa-1,4,7-trien-2,7-dicarbonsäure
6-Oxa-undeca-1,10-dien-2,10-dicarbonsäure
5,8-Dioxa-dodeca-1,11-dien-2,11-dicarbonsäure
5,8,11-Trioxa-pentadeca-1,14-dien-2,14-dicarbonsäure
1,2-Bis-(2-carboxy-prop-2-en-yl)benzol
1,3-Bis-(2-carboxy-prop-2-en-yl)benzol
1,4-Bis-(2-carboxy-prop-2-en-yl)benzol
1,4-Bis-(2-carboxy-prop-2-en-yl)cyclohexan.

Es hat sich gezeigt, daß Kopierschichten mit Verbindungen der Formel I, in denen der Rest $R_1$ aus einer 3 Atome enthaltenden Kette besteht, z. B. aus dem Propylen-1,3-, 2-Oxa-propylen-1,3- oder 2,2-Dimethylpropylen-1,3-rest, die höchste Lichtempfindlichkeit aufweisen, da möglicherweise zusätzlich Cyclopolymerisationsreaktionen ablaufen können. Dies trifft insbesondere für Verbindungen I mit dem Trimethylenrest als $R_1$ zu.

Geeignete Verbindungen I dieses Typs sind z. B.

2,6-Dinitro-hepta-1,6-dien,
2,6-Bis(äthylsulfonyl)-hepta-1,6-dien,
2,6-Bis(phenylsulfonyl)-hepta-1,6-dien,
2,6-Bis(dimethoxyphosphinyl)-hepta-1,6-dien,
2,6-Dicyano-hepta-1,6-dien,
2,6-Diformyl-hepta-1,6-dien,
2,6-Bis-(oximino)-hepta-1,6-dien,
2,6-Bis-phenylhydrazino-hepta-1,6-dien,
2,6-Diacetyl-hepta-1,6-dien,
2,6-Dibenzoyl-hepta-1,6-dien,
Hepta-1,6-dien-2,6-dicarbonsäure,
Hepta-1,6-dien-2,6-dicarbonsäuredimethylester,
Hepta-1,6-dien-2,6-dicarbonsäurediäthylester,
Hepta-1,6-dien-2,6-dicarbonsäurediphenylester,
Hepta-1,6-dien-2,6-dithiocarbonsäureäthylester,
Hepta-1,6-dien-2,6-dithiocarbonsäurephenylester,
Hepta-1,6-dien-2,6-dicarbonsäureamid,
Hepta-1,6-dien-2,6-dithiocarbonsäureamid,
Hepta-1,6-dien-2,6-dicarbonsäureäthylamid,
Hepta-1,6-dien-2,6-dicarbonsäurediäthylamid,
Hepta-1,6-dien-2,6-dicarbonsäureanilid und die gemischten Imide und Anhydride aus
Hepta-1,6-dien-2,6-dicarbonsäure und
Essigsäure, Benzoesäure, Acrylsäure oder Methacrylsäure.

Ein wesentlicher Vorteil der erfindungsgemäßen Gemische besteht nun darin, daß die polymerisierbaren, einheitlich und reproduzierbar darstellbaren Verbindungen I, insbesondere solche, die den Trimethylenrest $R_1$ enthalten, in der Kopierschicht für die sehr hohe Lichtempfindlichkeit verantwortlich sind. Durch die Auswahl geeigneter elektronenanziehender Gruppen A kann man dann den unterschiedlichen Anforderungen, die in der Praxis an Kopierschichten gestellt werden, gerecht werden.

Auf diese Weise können z. B. die Verträglichkeit der neuen polymerisierbaren Verbindungen mit Bindemitteln sowie die Flexibilität, die mechanische Festigkeit, die Lösungsmittelbeständigkeit oder die Entwickelbarkeit der Schicht den unterschiedlichen Bedürfnissen angepaßt werden.

Den erfindungsgemäßen Verbindungen können mit Vorteil auch herkömmliche polymerisierbare Verbindungen, die zwei oder mehr polymerisierbare Acryl- oder Methacrylsäureestergruppen enthalten, zugesetzt werden, wobei selbst-verständlich zu beachten ist, daß durch diese die durch die Verwendung der neuen polymerisierbaren Verbindungen in dem photopolymerisierbaren Gemisch erzielten, oben erläuterten Vorteile nicht zu stark herabgesetzt werden. Im allgemeinen sollten nicht mehr als 70 Gew.-%

der Gesamtmenge an Monomeren, bevorzugt nicht mehr als 60 %, aus Acrylestern bestehen.

Von den bekannten polymerisierbaren Verbindungen werden insbesondere Acryl- oder Methacrylester mehrwertiger aliphatischer Alkohole bevorzugt, ganz besonders Verbindungen der Formel

$$R_3 - C(CH_2 - O - \overset{\overset{O}{\|}}{C} - \underset{\underset{CH_2}{\|}}{C} - R_4)_3$$

Darin bedeuten :

$R_3$ H, eine Alkylgruppe mit 1 bis 6 C-Atomen, vorzugsweise eine Methyl- oder Äthylgruppe, eine Nitro- oder Methylolgruppe und

$R_4$ H oder eine Methylgruppe.

Geeignete Verbindungen dieser Formel sind z. B. Triacrylate und Trimethacrylate des Trimethylolmethans, Trimethyloläthans, Trimethylolpropans, Trimethylolnitromethans und Pentaerythrits.

Die Gesamtmenge an polymerisierbaren Verbindungen in dem photopolymerisierbaren Gemisch liegt zwischen 10 und 80, vorzugsweise zwischen 20 und 60 Gew.-%.

Die neuen photopolymerisierbaren Gemische können je nach geplanter Anwendung und je nach den gewünschten Eigenschaften verschiedenartige Stoffe als Zusätze enthalten. Beispiele sind :

Inhibitoren zur Verhinderung der thermischen Polymerisation der Massen,
Wasserstoffdonatoren,
die sensitometrischen Eigenschaften derartiger Schichten modifizierende Stoffe,
Farbstoffe,
gefärbte und ungefärbte Pigmente,
Farbbildner,
Indikatoren,
Weichmacher usw.

Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des kurzwelligen sichtbaren Lichts entspricht. Geeignet ist insbesondere langwellige UV-Strahlung, aber auch Elektronen-, Röntgen- und Laserstrahlung.

Als Photoinitiatoren in dem erfindungsgemäßen Gemisch können eine Vielzahl von Substanzen Verwendung finden. Beispiele sind Benzoin, Benzoinäther, Mehrkernchinone, z. B. 2-Äthyl-anthrachinon, Acridinderivate, z. B. 9-Phenyl-acridin, 9-p-Methoxyphenyl-acridin, 9-Acetylaminoacridin, Benz(a)acridin ; Phenazinderivate, z. B. 9,10-Dimethyl-benz(a)phenazin, 9-Methyl-benz(a)phenazin, 10-Methoxy-benz(a)phenazin ; Chinoxalinderivate, z. B. 6,4',4"-Trimethoxy-2,3-diphenylchinoxalin, 4'4"-Dimethoxy-2,3-diphenyl-5-aza-chinoxalin ; Chinazolinderivate und bestimmte Trichlormethyl-s-triazine. Die Menge an Photoinitiator liegt zwischen 0,1 und 10 Gew.-%, bezogen auf die nichtflüchtigen Anteile des Gemischs.

Wenn die Bebilderung mit Elektronenstrahlung durchgeführt wird, sind neben den bekannten für sichtbares und nahes UV-Licht empfindlichen Photoinitiatoren auch solche geeignet, deren Absorptionsbereiche im kürzerwelligen Teil des elektromagnetischen Spektrums liegen und die damit gegenüber Tageslicht wenig empfindlich sind. Dies hat den Vorteil, daß man die Aufzeichnungsmaterialien ohne Lichtausschluß handhaben kann und daß die Materialien besser lagerfähig gemacht werden können.

Als Beispiele für derartige Starter sind Tribommethylphenyl-sulfon, 2,2',4,4',6,6'-Hexabrom-diphenylamin, Pentabromäthan, 2,3,4,5-Tetrachlor-anilin, Pentaerythrit-tetrabromid, Chlorterphenylharze oder chlorierte Paraffine zu nennen.

Als Wasserstoffdonatoren werden in der Hauptsache aliphatische Polyäther verwendet. Gegebenenfalls kann diese Funktion auch vom Bindemittel oder von dem polymerisierbaren Monomeren übernommen werden, wenn diese labile Wasserstoffatome besitzen.

Als Bindemittel können eine Vielzahl löslicher organischer, vorzugsweise gesättigter Polymerisate Einsatz finden. Als Beispiele seien genannt : Polyamide, Polyvinylester, Polyvinylacetale, Polyvinyläther, Polyacrylsäureester, Polymethacrylsäureester, Polyester, Alkydharze, Polyacrylamid, Polyvinylalkohol, Polyäthylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z. B. Gelatine, Celluloseäther und dgl.

Mit besonderem Vorteil werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrig-alkalischen Entwirklern entwickeln lassen. Derartige Bindemittel können z. B. die folgenden Gruppen enthalten : $-COOH$, $-PO_3H_2$, $-SO_3H$, $-SO_2NH_2$, $-SO_2-NH-CO-$ und dgl. Als Beispiele hierfür seien genannt : Maleinatharze, Polymerisate aus N-(p-Tolyl-sulfonyl)-carbaminsäure-(β-methacryloyloxy-äthyl) ester und Mischpolymerisate dieser und ähnlicher Monomerer mit anderen Monomeren und Styrol-Maleinsäureanhydrid-Mischpolymerisate. Methylmethacrylat-Methacrylsäure-Mischpolymerisate und Mischpolymerisate aus Methacrylsäure, Alkylmethacrylaten und Methylmethacrylat und/oder Styrol, Acrylnitril u. a., wie sie in den DE-B-20 64 080 und 23 63 806 beschrieben sind, werden bevorzugt.

Die Menge des Bindemittels beträgt 20 bis 90, vorzugsweise 40 bis 80 Gew.-% der nichtflüchtigen Bestandteile des Gemischs.

Das photopolymerisierbare Gemisch kann für die verschiedensten Anwendungen Einsatz finden, beispielsweise zur Herstellung von Sicherheitsglas, von Lacken, die durch Licht oder Korpuskularstrahlen, z. B. Elektronenstrahlen, gehärtet werden, auf dem Dentalgebiet und insbesondere als lichtempfindliches Kopiermaterial auf dem Reproduktionsgebiet.

Die detaillierte Beschreibung der Erfindung beschränkt sich auf dieses Anwendungsgebiet, jedoch ist die Erfindung nicht hierauf beschränkt. Als Anwendungsmöglichkeiten auf diesem Gebiet seien genannt : Kopierschichten für die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw. Weiter sind die Gemische zur photomechanischen Herstellung von Ätzreservagen, z. B. für die Fertigung von Namensschildern, von kopierten Schaltungen und für das Formteilätzen, anwendbar. Besondere Bedeutung haben die erfindungsgemäßen Gemische als Kopierschichten für die photomechanische Herstellung von Flachdruckformen und von Ätzreservagen, insbesondere als vorsensibilisierte Materialien.

Die gewerbliche Verwertung des Gemischs für die genannten Anwendungszwecke kann in der Form einer flüssigen Lösung oder Dispersion, z. B. als sogenannter Kopierlack, erfolgen, die vom Verbraucher selbst auf einen individuellen Träger z. B. zum Formteilätzen, für die Herstellung kopierter Schaltungen, von Siebdruckschablonen und dgl., aufgebracht wird. Das Gemisch kann auch als feste lichtempfindliche Schicht auf einem geeigneten Träger in Form eines lagerfähig vorbeschichteten lichtempfindlichen Kopiermaterials, z. B. für die Herstellung von Druckformen, vorliegen, Ebenso ist es für die Herstellung von Trockenresist geeignet.

Es ist im allgemeinen günstig, die Gemische während der Lichtpolymerisation dem Einfluß des Luftsauerstoffes weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Wachse, Polyvinylalkohol, Polyphosphate, Zucker usw..

Als Träger für mit dem erfindungsgemäßen Gemisch hergestellte Kopiermaterialien sind beispielsweise Aluminium, Stahl, Zink, Kupfer und Kunststoff-Folien, z. B. aus Polyäthylenterephthalat oder Cellulosacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen bzw. das Reflexionsvermögen des Trägers im aktinischen Bereich der Kopierschicht herabzusetzen (Lichthofschutz).

Die Herstellung der lichtempfindlichen Materialien unter Verwendung des erfindungsgemäßen Gemischs erfolgt in bekannter Weise.

So kann man dieses in einem Lösungsmittel aufnehmen und die Lösung bzw. Dispersion durch Gießen, Sprühen, Tauchen, Antrag mit Walzen usw. auf den vorgeschenen Träger als Film antragen und anschließend antrocknen. Dicke Schichten (z. B. von 250 μm und darüber) werden vorteilhaft durch Extrudieren oder Verpressen als selbsttragende Folie hergestellt, welche dann ggf. auf den Träger laminiert wird. Im Falle von Trockenresist werden Lösungen des Gemischs auf transparente Träger aufgebracht und angetrocknet. Die lichtempfindlichen Schichten — Dicke zwischen 10 und 100 μm — werden dann gleichfalls zunächst durch Laminieren zusammen mit dem temporären Träger auf das gewünschte Substrat auflaminiert.

Die Verarbeitung der Kopiermaterialien wird in bekannter Weise vorgenommen. Zur Entwicklung werden sie mit einer geeigneten Entwicklerlösung, bevorzugt einer schwach alkalischen wäßrigen Lösung, behandelt, wobei die unbelichteten Anteile der Schicht entfernt werden und die belichteten Bereiche der Kopierschicht auf dem Träger zurückbleiben.

Im folgenden werden Beispiele für das erfindungsgemäße Gemisch angegeben. Dabei wird zunächst die Herstellung einer Anzahl neuer polymerisierbarer Verbindungen beschrieben. Die Verbindungen wurden in den erfindungsgemäßen Kopiermaterialien als polymerisierbare Verbindungen 1-48 durchnumeriert und kehren unter dieser Bezeichnung in den Anwendungsbeispielen wieder.

In den Beispielen stehen Gewischtsteile (Gt) und Volumteile (Vt) im Verhältnis von g zu ccm. Prozent-und Mengenverhältnisse sind, wenn nichts anderes angegeben ist, in Gewichtseinheiten zu verstehen.

Allgemeine Vorschrift A
zur Herstellung von Verbindungen der Formel I

Zu der Lösung einer Base, z. B. Natriumalkoholat, und methylenaktiver Verbindung Alkyl-OOC—$CH_2$—A im Überschuß (Molverhältnis 1 : 5) in einem Lösungsmittel wie Alkohol oder Tetrahydrofuran wurden 0,5 Mol dihalogenalkan pro Mol Base zugetropft. Nach 2- bis 8-stündigem Erhitzen unter Rückfluß wurde zunächst das Lösungsmittel, dann die überschüssige methylenaktive Verbindung im Vakuum abdestilliert. Der Rückstand wurde mit Wasser versetzt, angesäuert und mit Methylenchlorid extrahiert. Das nach Trocknen, Filtrieren und Verdampfen des Lösungsmittels verbliebene Bisalkylierungsprodukt wurde Fraktioniert im Vakuum destilliert (Ausbeute a).

Das nach der Destillation erhaltene Bisalkylierungsprodukt wurde mit Kaliumhydroxid im Molverhältnis 1 : 2 in Alkohol versetzt. Nach 12-stündigem Rühren bei Raumtemperatur wurde der Alkohol abdestilliert. Nach Zugabe von Wasser und Extraktion mit Äther wurde die wäßrig-alkalische Phase mit konzentrierter Salzsäure angesäuert. Aus der mit Äther extrahierten wäßrig-sauren Phase wurde die Dicarbonsäure als Rohprodukt gewonnen (Ausbeute b), das zunächst mit Diäthylamin im Molverhältnis 1 : 2 und anschließend mit 85 ml 35 %iger waßriger Formaldehydlösung pro Mol Diäthylamin versetzt wurde. Im Anschluß an die deutlich sichtbare $CO_2$-Entwicklung bildeten sich im allgemeinen innerhalb von 12 Stunden zwei Phasen. Nach dem Ansäuern wurde die wäßrige Phase mit Äther extrahiert. Der nach der üblichen Aufarbeitung erhaltene Rückstand wurde fraktioniert im Vakuum destilliert (Ausbeute c).

Die so erhaltenen Verbindungen 1 bis 13 weisen mit den zugeordneten Strukturen übereinstimmende IR- und NMR-Spektren auf und sind durch ihre Analysendaten belegt. Die Ausbeuten der einzelnen Stufen und die NMR-Signale der vinylischen Protonen sind in Tabelle 1 angegeben.

Tabelle 1

Verbindungen der allgemeinen Formel I

| Verbindung Nr. | $R_1$ | A | Ausbeute % d.Th. | NMR-Signale der vinylischen Protonen δ (ppm) ($CDCl_3$) | |
|---|---|---|---|---|---|
| 1 | $-(CH_2)_2-$ | $COOC_2H_5$ | a) 6 * | 6,16 | 5,50 |
| | | | b) 83 | | |
| | | | c) 31 | | |
| 2 | $-(CH_2)_3-$ | $COOC_2H_5$ | a) 81 | 6,22 | 5,59 |
| | | | b) 97 | | |
| | | | c) 54 | | |
| 3 | $-(CH_2)_4-$ | $COOC_2H_5$ | a) 2 ** | 6,14 | 5,52 |
| | | | b) 79 | | |
| | | | c) 50 | | |
| 4 | $-(CH_2)_5-$ | $COOC_2H_5$ | a) 31 | 6,13 | 5,50 |
| | | | b) 99 | | |
| | | | c) 48 | | |
| 5 | $-(CH_2)_6-$ | $COOC_2H_5$ | a) 89 | 6,10 | 5,47 |
| | | | b) 99 | | |
| | | | c) 58 | | |
| 6 | $-(CH_2)_{10}-$ | $COOC_2H_5$ | a) 77 | 6,12 | 5,50 |
| | | | b) 98 | | |
| | | | c) 62 | | |
| 7 | $-(CH_2)_2-O-(CH_2)_2-$ | $COOC_2H_5$ | a) 18 | 6,22 | 5,62 |
| | | | b) 94 | | |
| | | | c) 32 | | |

(Fortsetzung)

| Verbindung Nr. | $R_1$ | A | Ausbeute % d.Th. | NMR-Signale der vinylischen Protonen δ (ppm) (CDCl₃) | |
|---|---|---|---|---|---|
| 8 | $-(CH_2CH_2-O)_2(CH_2)_2$ | $-COOC_2H_5$ | a) 49<br>b) 95<br>c) 38 | 6,23 | 5,65 |
| 9 | $-(CH_2CH_2-O)_3(CH_2)_2$ | $-COOC_2H_5$ | a) 32<br>b) 99<br>c) 50 | 6,24 | 5,66 |
| 10 | $-CH_2-$ 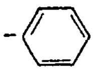 $-CH_2-$ | $COOC_2H_5$ | a) 60<br>b) 99<br>c) 62 | 6,20 | 5,42 |
| 11 | $-CH_2-$ 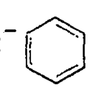 $-CH_2-$ | $COOC_2H_5$ | a) 78<br>b) 99<br>c) 46 | 6,22 | 5,43 |
| 12 | $-CH_2-$ 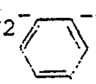 $-CH_2-$ | $COOC_2H_5$ | a) 63<br>b) 93<br>c) 28 | 6,24 | 5,23 |
| 13 | $-(CH_2)_3-$ | CN | a) 55<br>b) 80<br>c) 62 | 5,85 | 5,71 |

* Hauptreaktion bei der Bisalkylierung : Dreiringbildung
** Hauptreaktion bei der Bisalkylierung : Fünfringbildung

## Allgemeine Vorschrift B
## zur Herstellung von Alkadiendicarbonsäuren

Die nach Vorschrift A erhaltenen Dicarbonsäureester III und Kaliumhydroxid wurden im Molverhältnis 1 : 6 in wäßriger Lösung 5 Stunden unter Rückfluß erhitzt oder mehrere Tage bei Raumtemperatur gerührt. Die wäßrige Phase wurde angesäuert und mit Essigester extrahiert. Die organische Phase wurde mit Wasser gewaschen, getrocknet, filtriert und vom Lösungsmittel befreit.

Die zurückbleibenden Kristalle wurden aus dem angegebenen Lösungsmittel umkristallisiert.

Die so erhaltenen ungesättigten Dicarbonsäuren 14 bis 24 wiesen mit den zugeordneten Strukturen übereinstimmende Analysendaten, IR- und NMR-Spektren auf. Zur Charakterisierung der Verbindungen sind ihre Schmelzpunkte und die NMR-Signale der vinylischen Protonen in Tabelle 2 angegeben.

(Siehe Tabelle 2, Seite 10 f.)

Tabelle 2

Verbindungen der allgemeinen Formel II

$A_1 = OH$

| Verbindung Nr. | $R_1$ | Ausbeute % d.Th. | Schmelzpunkt °C | NMR-Signale der vinylischen Protonen δ (ppm) | ($d_6$-DMSO) |
|---|---|---|---|---|---|
| 14 | $-(CH_2)_2-$ | 69 | 185-187 * | 5,97 | 5,47 |
| 15 | $-(CH_2)_3-$ | 77 | 105-106 ** | 5,97 | 5,50 |
| 16 | $-(CH_2)_4-$ | 50 | 170-172 * | 5,94 | 5,48 |
| 17 | $-(CH_2)_5-$ | 77 | 95 *** | 5,93 | 5,47 |
| 18 | $-(CH_2)_6-$ | 69 | 127-128 * | 5,93 | 5,44 |
| 19 | $-(CH_2)_{10}-$ | 65 | 108-110 ** | 5,93 | 5,46 |
| 20 | $-(CH_2)_2-O-(CH_2)_2-$ | 56 | 94- 95 ** | 6,00 | 5,55 |
| 21 | $-(CH_2CH_2-O)_2-(CH_2)_2-$ | 64 | 64- 66 *** | 6,33 | 5,74 **** |
| 22 | $-CH_2-$ 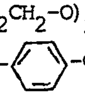 $-CH_2-$ | 68 | 209-211 * | 6,02 | 5,45 |
| 23 | $-CH_2-$ 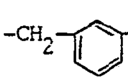 $-CH_2-$ | 50 | 145-147*** | 6,05 | 5,45 |
| 24 | $-CH_2-$ 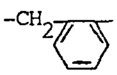 $-CH_2-$ | 51 | 192-194 ** | 6,04 | 5,17 |

* Umkristallisiert aus Essigester
** Umkristallisiert aus Isopropyläther
*** Umkristallisiert aus Cyclohexan/Essigester
**** NMR-Spektrum in $CDCl_3$ gemessen

## Allgemeine Vorschrift C zur Herstellung von Alkadiendicarbonsäureestern

Die nach Vorschrift B erhaltenen Dicarbonsäuren II wurden mit einwertigem Alkohol im Molverhältnis 1 : 10 in Gegenwart von konzentrierter Schwefelsäure als Katalysator 5 Stunden unter Rühren auf 100-150 °C erhitzt. Der überschüssige Alkohol wurde weitgehend durch Destillation entfernt. Der verbleibende Rückstand wurde zwischen Methylenchlorid und Wasser verteilt und die organische Phase getrocknet und filtriert. Der nach dem Verdampfen des Lösungsmittels verbleibende Rest wurde fraktioniert im Vakuum destilliert oder umkristallisiert. Man kann die gleichen Verbindungen auch erhalten, wenn man zusätzlich ein wasserschleppendes Lösungsmittel, z. B. Toluol, einsetzt. Unter diesen Reaktionsbedingungen kann der Alkoholüberschuß reduziert werden. Das entstehende Reaktionswasser wird durch Erhitzen unter Rückfluß mit Hilfe eines Wasserabscheiders entfernt.

Die so erhaltenen ungesättigten Dicarbonsäureester 25 bis 32 wiesen die gleichen spektroskopischen Merkmale auf wie die nach der allgemeinen Vorschrift A hergestellten Dicarbonsäureester 1 bis 12. Für die in Tabelle 3 aufgeführten Verbindungen sind die NMR-Signale der vinylischen Protonen zur Charakterisierung angegeben.

Tabelle 3

Verbindungen der allgemeinen Formel III

$R_1 = (CH_2)_3$

| Verbindung Nr. | $R_2$ | Ausbeute, % d.Th. | NMR-Signale der vinylischen Protonen δ (ppm) (CDCl$_3$) | |
|---|---|---|---|---|
| 25 | $-(CH_2)_3CH_3$ | 68 | 6,13 | 5,50 |
| 26 | $-CH_3$ | 59 | 6,13 | 5,53 |
| 27 | $-(CH_2)_{11}CH_3$ | 49 | 6,10 | 5,48 |
| 28 | $-CH_2-CH=CH_2$ | 56 | 6,17 | 5,53 |
| 29 | $-(CH_2)_2OC_6H_5$ | 90 | 6,15 | 5,53 |
| 30 | $-(CH_2)_2OCH_3$ | 81 | 6,19 | 5,57 |
| 31 | $-(CH_2)_2Br$ | 85 | 6,24 | 5,60 |
| 32 | $-(CH_2)_2C_6H_5$ | 82 | 6,10 | 5,48 |
| 32a | $-CH_2-$ 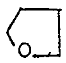 | 47 | 6,19 | 5,53 |

Allgemeine Vorschrift D
zur Herstellung von weiteren Derivaten der Alkadiendicarbonsäuren

Die nach Vorschrift B erhaltenen Dicarbonsäuren II wurden in überschüssigem Thionylchlorid 2 Stunden unter Rückfluß zum Sieden erhitzt. Nach der Entfernung des überschüssigen Thionylchlorids wurde das rohe Dicarbonsäurechlorid unter Kühlung in die Lösung einer H-aktiven Verbindung — z. B. einer Hydroxyverbindung, eines Amins, einer Thioverbindung, einer Säure oder eines Amids — in absolutem Äther oder Tetrahydrofuran und der zum Abfangen des Chlorwasserstoffs äquivalenten Menge Pyridin eingetragen. Nach mehrstündigem Rühren bei Raumtemperatur wurde die ätherische Lösung zunächst mit verdünnter Säure, dann mit neutralem Wasser gewaschen. Nach Trocknen und Entfernen des Lösungsmittels wurde der Rückstand durch Destillation oder Kristallisation gereinigt.

Die so erhaltenen Säurederivate 33 bis 37 wiesen mit den zugeordneten Strukturen übereinstimmende IR- und NMR-Spektren auf. Die für die vinylischen Protonen charakteristischen Signale im NMR-Spektrum sind in Tabelle 4 angegeben.

Tabelle 4

Verbindungen der allgemeinen Formel II

$R_1 = (CH_2)_3$

| Verbindung Nr. | $A_1$ | Ausbeute % d. Th. | NMR-Signale der vinylischen Protonen δ (ppm) (CDCl$_3$) | |
|---|---|---|---|---|
| 33* | $-NH_2$ | 56 | 5,59 | 5,20 ** |
| 33a | $-N(C_2H_5)_2$ | 35 | 5,08 | |
| 34 | $-NHC_6H_5$ | 72 | 5,64 | 5,31 |
| 35 | $-OC_6H_5$ | 67 | 6,38 | 5,73 |
| 36 | $-SC_6H_5$ | 75 | 6,19 | 5,64 |
| 37 | $-OCOC_6H_5$ | 87 | 6,38 | 5,89 |

* Das Bis-Amid wurde durch Eintragen des Bis-Säurechlorids in eine wäßrige Ammoniaklösung erhalten
** Das NMR-Spektrum des Bis-Amids wurde in $d_6$-DMSO aufgenommen.

Allgemeine Vorschrift E
zur Herstellung von Dinitroalkadienen

Zu einer Lösung von 0,1 Mol Diäthylamin in 15 ml Wasser wurde bei 0 °C unter Rühren 0,1 Mol Formaldehyd als wäßrige Lösung zugetropft. Die Temperatur wurde unter 10 °C gehalten. Nach 30 Minuten wurden 50 mMol Dinitroalkan zugetropft. Es wurde noch 1,5 Stunden bei 15 °C gerührt und mit Äther extrahiert. Die ätherlösliche Bis-Diäthylaminomethylverbindung wurde durch Einleiten von trockenem HCl-Gas als Dihydrochlorid gefällt. Die Thermolyse des Mannichbasen-Dihydrochlorids wurde im Hochvakuum bei 110°-150 °C durchgeführt. Eine Reinigung der Dinitroalkadiene erfolgte durch Destillation oder Umkristallisation. Zur Charakterisierung der auf diese Weise hergestellten Verbindung 38 sind die NMR-Signale der vinylischen Protonen in Tabelle 5 angegeben.

Allgemeine Vorschrift F
zur Herstellung von Diformylalkadienen

Eine wäßrige Lösung von 0,5 Mol Alkandialdehyd, 1 Mol Formaldehyd und 1 Mol Dimethylammoniumchlorid wurde 24 Stunden unter Rückfluß zum Sieden erhitzt. Das Rohprodukt wurde einer Wasserdampfdestillation unterworfen. Das Destillat wurde mit Äther extrahiert. Nach dem Trocknen über Natriumsulfat wurde das Lösungsmittel der organischen Phase entfernt. Die auf diese Weise hergestellte Verbindung 39 wird durch die NMR-Signale der vinylischen Protonen in Tabelle 5 charakterisiert.

Allgemeine Vorschrift G
zur Herstellung von Dicyanoalkadienen

Zu einer Lösung von 0,1 Mol der nach Vorschrift B erhaltenen Dicarbonsäuren in 100 ml Toluol wurden 0,22 Mol Chlorsulfonylisocyanat getropft.

Bis zum Ende der $CO_2$-Abspaltung wurde noch 3 Stunden bei 60 °C gerührt. Nach dem Abkühlen auf Raumtemperatur wurden 40 g Dimethylformamid zugesetzt, das Gemisch auf Eis gegossen und die Phasen getrennt. Die organische Phase wurde gewaschen, getrocknet und vom Lösungsmittel befreit. Das zurückbleibende Öl wurde fraktioniert destilliert. Die nach Vorschrift G erhaltenen Dinitrile sind identisch mit den nach Vorschrift A hergestellten Dicyan-Verbindungen.

Ausbeute und NMR-Signale der vinylischen Protonen der nach diesem Verfahren hergestellten Verbindung 40 sind in Tabelle 5 angegeben.

Allgemeine Vorschrift H
zur Herstellung von Diformylalkadienen

Eine Lösung von 0,1 Mol der nach Vorschrift A oder G erhaltenen Dicyanoalkadiene in 250 ml wasserfreiem Toluol wurde unter Stickstoff bei – 30 °C tropfenweise mit einer Lösung von 0,2 Mol Diisobutylaluminiumhydrid in Toluol versetzt. Nach 2 Stunden weiterem Rühren bei – 30 °C wurde mit verdünnter Schwefelsäure angesäuert und die organische Phase abgetrennt. Die Toluolphase wurde gewaschen, getrocknet und vom Lösungsmittel befreit. Eine Reinigung des zurückbleibenden Öls erfolgte gegebenenfalls durch Destillation. Ausbeute und NMR-Signale der vinylischen Protonen der nach dieser Vorschrift hergestellten Verbindungen 41 und 42 sind in Tabelle 5 angegeben.

Allgemeine Vorschrift I
zur Herstellung von Diketoalkadienen

Zu einer Lösung von 0,1 Mol Diketoalkan in 50 ml Bis-(dimethylamino)-methan wurden 50 ml Acetanhydrid getropft. Anschließend wurde noch 8 Stunden auf 90 °C erhitzt. Nach Entfernen der leichtsiedenden Bestandteile wurde das erhaltene Rohprodukt durch Säulenchromatographie und nachfolgende Destillation oder Umkristallisation gereinigt.

Ausbeute und NMR-Signale der vinylischen Protonen der nach dieser Vorschrift hergestellten Verbindungen 45 bis 47 sind in Tabelle 5 angegeben.

Allgemeine Vorschrift K
zur Herstellung von Diketoalkadienen

Die nach Vorschrift 8 erhaltenen Dicarbonsäuren II wurden in überschüssigem Thionylchlorid 2 Stunden unter Rückfluß zum Sieden erhitzt. Nach der Entfernung des überschüssigen Thionylchlorids wurde das Dicarbonsäurechlorid im Vakuum destilliert. Das Säurechlorid wurde bei 0 °C in Stickstoffatmosphäre zu einer Lösung von äquimolaren Mengen Aluminiumalkyl in Methylenchlorid getropft. Nach beendeter Zugabe wurde eine Stunde nachgerührt. Das Reaktionsgemisch ließ man anschließend auf Wasser fließen. Das Rohprodukt konnte durch Wasserdampfdestillation gereinigt werden.

Ausbeute und NMR-Signale der vinylischen Protonen der nach dieser Vorschrift hergestellten Verbindung 48 sind in Tabelle 5 angegeben.

Tabelle 5

Verbindungen der allgemeinen Formel I

| Verbindung Nr. | $R_1$ | A | Ausbeute % d. Th. | NMR-Signale der vinylischen Protonen $\delta$ (ppm) ($CDCl_3$) | |
|---|---|---|---|---|---|
| 38 | $-(CH_2)_3-$ | $NO_2$ | 30 | 6,45 | 5,60 |
| 39 | $-CH_2-$ | CHO | 25 | 6,28 | 6,08 |
| 40 | $-(CH_2)_6-$ | CN | 73 | 5,80 | 5,68 |
| 41 | $-(CH_2)_3-$ | CHO | 51 | 6,25 | 6,00 |
| 42 | $-(CH_2)_6-$ | CHO | 59 | 6,23 | 5,97 |
| 43 | $-CH_2-$ | C=N-OH * | 49 | 5,32 | 5,19 ** |
| 44 | $-CH_2-$ | $C=N-NHC_6H_5$ * | 81 | 5,18 ** | |
| 45 | $-CH_2-$ | $COC_6H_5$ | 23 | 5,96 | 5,70 |
| 46 | $-(CH_2)_2-$ | $COC_6H_5$ | 61 | 5,87 | 5,64 |
| 47 | $-(CH_2)_3-$ | $COC_6H_5$ | 69 | 5,85 | 5,60 |
| 48 | $-(CH_2)_3-$ | $COCH_3$ | 51 | 5,99 | 5,72 |

* Oxime und Hydrazone wurden in üblicher Weise aus den entsprechenden Aldehyden und Ketonen gewonnen
** Das NMR-Spektrum wurde in $d_6$-DMSO aufgenommen

## Beispiel 1

Als Schichtträger für Druckplatten wurde elektrochemisch aufgerauhtes und anodisiertes Aluminium mit einer Oxidschicht von 3 g/m² verwendet, das mit einer wäßrigen Lösung von Polyvinylphosphonsäure vorbehandelt worden war. Der Träger wurde mit einer Lösung folgender Zusammensetzung überzogen :

11,7 Gt einer 34,7 %igen Lösung eines Methylmethacrylat/Methacrylsäure-Mischpolymerisats mit der Säurezahl 110 und dem mittleren Mol-Gewicht 35 000 in Methyläthylketon,
2,0 Gt einer der Verbindungen 1-48 (Tabelle 6),
2,0 Gt Trimethyloläthantriacrylat,
0,07 Gt-9-Phenyl-acridin,
0,07 Gt 4-Dimethylamino-4'-methyl-dibenzalaceton,
0,04 Gt eines Azofarbstoffs aus 2,4-Dinitro-6-chlor-benzoldiazoniumsalz und 2-Methoxy-5-acetyl-amino-N-cyanäthyl-N-hydroxyäthylanilin,
38,0 Gt Äthylenglykolmonoäthyläther,
13,5 Gt Butylacetat.

Das Auftragen erfolgte durch Aufschleudern in der Weise, daß ein Trockengewicht von 2,8-3 g/m² erhalten wurde. Anschließend wurde die Platte 2 Minuten bei 100 °C im Umlufttrockenschrank getrocknet.

Die lichtempfindliche beschichtete Platte wurde mit einer 15 %igen wäßrigen Lösung von Polyvinylalkohol (12 % Restacetylgruppen, K-Wert 4) beschichtet. Nach dem Trocknen wurde eine Deckschicht mit einem Gewicht von 4-5 g/m² erhalten.

Die erhaltene Druckplatte wurde mittels einer 5 kW-Metallhalogenidlampe im Abstand von 110 cm unter einem 13 stufigen Belichtungskeil mit Dichteinkrementen von 0,15 30 Sekunden belichtet.

Anschließend wurde die Platte mit einem Entwickler folgender Zusammensetzung entwickelt :

120 Gt Natriummetasilikat · 9 $H_2O$,
2,13 Gt Strontiumchlorid,

1,2 Gt nichtionogenes Netzmittel (Kokosfettalkohol-Polyoxyäthylenäther mit ca. 8 Oxyäthyleneinheiten),
0,12 Gt Antischaummittel,
4 000 Gt vollentsalztes Wasser.

Die Platte wurde mit 1 %iger Phosphorsäure sauer gestellt und mit fetter Druckfarbe eingefärbt. Es wurden die folgenden vollvernetzten Keilstufen erhalten :

Tabelle 6

| Verbindung Nr. | Keilstufen |
|---|---|
| 1 | 3 |
| 2 | 6 |
| 3 | 2 |
| 4 | 3 |
| 5 | 3 |
| 6 | 1 |
| 7 | 2 |
| 8 | 3 |
| 9 | 2 |
| 10 | 1 |
| 11 | 1 |
| 12 | 1 |
| 13 | 4 |
| 14 | 2 |
| 15 | 3 |
| 16 | 2 |
| 17 | 3 |
| 18 | 2 |
| 19 | 1 |
| 20 | 1 |
| 21 | 1 |
| 22 | 1/2 |
| 23 | 1/2 |
| 24 | 1 |
| 25 | 3 |
| 26 | 4 |
| 27 | 1 |
| 28 | 5 |
| 29 | 2 |
| 30 | 5 |
| 31 | 1 |
| 32 | 2 |
| 32a | 2 |
| 33 | 3 |
| 33a | 2 |
| 34 | 2 |
| 35 | 2 |
| 36 | 1 |
| 37 | 2 |
| 38 | 1 |
| 39 | 2 |
| 40 | 3 |
| 41 | 2 |
| 42 | 1 |
| 43 | 1 |
| 44 | 1 |
| 45 | 1 |
| 46 | 1 |
| 47 | 2 |
| 48 | 2 |

Beispiel 2

Auf den in Beispiel 1 angegebenen Schichtträger wurde eine Lösung folgender Zusammensetzung so aufgeschleudert, daß ein Schichtgewicht von 3 $g/m^2$ erhalten wurde :

11,7 Gt der in Beispiel 1 angegebenen Mischpolymerisatlösung,
38,0 Gt Äthylenglykolmonoäthyläther,
13,5 Gt Butylacetat,
3,9 Gt eines der in Tabelle 7 angegebenen Monomeren,
0,07 Gt 9-Phenyl-acridin,
0,04 Gt des in Beispiel 1 angegebenen Azofarbstoffs,
0,07 Gt 4-Dimethylamino-4'-methyl-dibenzalaceton.

Die Platte wurde in gleicher Weise wie in Beispiel 1 weiterverarbeitet. Es wurde die folgende Anzahl vollvernetzter Keilstufen erhalten :

Tabelle 7

| Verbindung Nr. | Belichtungszeit (Sekunden) | Keilstufen |
|---|---|---|
| 1 | 15 | 1 |
| | 30 | 3 |
| 2 | 15 | 3 |
| | 30 | 6 |
| 4 | 15 | 1 |
| | 30 | 2 |
| 5 | 15 | 1 |
| | 30 | 3 |
| 8 | 15 | 1 |
| | 30 | 3 |
| 13 | 15 | 1 |
| | 30 | 3 |
| 15 | 15 | 1 |
| | 30 | 3 |
| 17 | 15 | 1 |
| | 30 | 3 |
| 25 | 15 | 1 |
| | 30 | 3 |
| 26 | 15 | 2 |
| | 30 | 4 |
| 28 | 15 | 2 |
| | 30 | 4 |
| 30 | 15 | 2 |
| | 30 | 4 |

Vergleichbare Ergebnisse wurden erhalten, wenn an Stelle von 9-Phenylacridin das 2,2-Dimethoxy-2-phenylacetophenon oder 2-(4-Äthoxy-naphth-1-yl)-4,6-bis-trichlormethyl-s-triazin oder 2-(Acenaphth-5-yl)-4,-6-bis-trichlormethyl-s-triazin verwendet wurde.

Mit Verbindung 2 wurde ein Druckversuch durchgeführt. Dazu wurde die mit fetter Farbe eingefärbte Offsetdruckplatte in eine handelsübliche Druckmaschine (Heidelberg Typ GTO) eingespannt. Nach 200 000 Drucken wurde der Druckversuch abgebrochen, obwohl noch keine Ausbrüche im 60er Raster festzustellen waren.

Beispiel 3

Auf den in Beispiel 1 angegebenen Schichtträger wurde eine Lösung folgender Zusammensetzung so aufgeschleudert, daß ein Schichtgewicht von 3,5 g/m² erhalten wurde :

10,0 Gt einer 21,7 %igen Lösung eines Terpolymerisates aus Styrol, n-Hexylmethacrylat und Methacrylsäure (10 : 60 : 30) mit der Säurezahl 190 in Butanon,

2,0 Gt der Verbindung 2,
0,06 Gt 9-Phenyl-acridin, und

0,03 Gt Methylviolett (C. I. 42 535) in
18,0 Gt Butanon und
7,5 Gt Butylacetat.

Die beschichtete Platte wurde anschließend 2 Minuten bei 100 °C im Umlufttrockenschrank getrocknet und mit einer Deckschicht wie in Beispiel 1 versehen. Die Platte wurde unter einem 13-stufigen Belichtungskeil wie in Beispiel 1 beschrieben 4, 8, 15 und 30 Sekunden belichtet und mit einem Entwickler folgender Zusammensetzung entwickelt :

5,3 Gt Natrium-metasilikat · $9H_2O$
3,4 Gt tert. Natriumphosphat · $12H_2O$
0,3 Gt sec. Natriumphosphat · $12H_2O$
91,0 Gt vollentsalztes Wasser

Die Platte wurde mit 1 %iger Phosphorsäure sauer gestellt und mit fetter Druckfarbe eingefärbt. Die Auszählung der vollvernetzten Glanzstufen ergab folgendes Bild :

| | Sekunden | | | |
|---|---|---|---|---|
| Belichtungszeit : MH-Lampe 5 kW | 4 | 8 | 15 | 30 |
| Entsprechende Vollvernetzte Glanzstufen | 1 | 3 | 5 | 7 |

## Beispiel 4

Eine Lösung, wie in Beispiel 3 beschrieben, wurde auf einen gereinigten Träger, der aus einem Isolierstoffmaterial mit 35 µm Kupferauflage bestand, so aufgeschleudert, daß eine Schichtdicke von ca. 5 µm erhalten wurde. Die Schicht wurde 5 Minuten bei 100 °C im Umlufttrockenschrank nachgetrocknet. Anschließend wurde eine Deckschicht wie in Beispiel 1 aufgebracht. Der Beschichtungs- und Trocknungsvorgang kann auch beidseitig durchgeführt werden.

Anschließend wurde mittels einer 5 kW MH-Lampe mit 140 cm Abstand unter einem Stufenkeil wie in Beispiel 1 beschrieben 2, 4, 8, 16, 32 und 64 Sekunden belichtet und die Platte mit 0,8 %iger Sodalösung in einen Sprühprozessor zwischen 30 und 60 Sekunden entwickelt.

Es wurden die folgenden vollvernetzten Keilstufen erhalten :

| Belichtungszeit [(Sekunden)] | Keilstufen |
|---|---|
| 2 | 1 |
| 4 | 2 |
| 8 | 5 |
| 16 | 7 |
| 32 | 9 |
| 64 | 11 |

Wenn die vernetzbare Schicht unter einer Schaltvorlage belichtet und entwickelt wurde, waren die vernetzten Bereiche gegen die in der Leiterplattentechnik übliche Eisen-III-chlorid-Lösung resistent. Die Ätzfestigkeit war gut.

## Beispiel 5

Eine Beschichtungslösung wurde aus

1,4 Gt eines Styrol/Maleinsäureanhydrid-Mischpolymerisats der Säurezahl 190 mit einem mittleren Molekulargewicht um 10 000,
1,3 Gt Verbindung 26,
0,2 Gt 1,6-Di-hydroxyäthoxy-hexan,
0,1 Gt Benz(a)phenazin,

0,02 Gt Farbstoff wie in Beispiel 1,
17,0 Gt Äthylenglykolmonoäthyläther

hergestellt und auf elektrolytisch aufgerauhtes 0,3 mm starkes Aluminium, wie in Beispiel 1 beschrieben, durch Aufschleudern aufgetragen und mit einer Deckschicht versehen. Belichtung, Entwicklung und Beurteilung erfolgten wie in Beispiel 1. Es wurden 3 Keilstufen erhalten.

Beispiel 6

Eine Beschichtungslösung wurde aus

1,4 Gt der Verbindung 2,
1,4 Gt eines Methylmethacrylat/Methacrylsäure-Mischpolymerisats mit dem mittleren Molekulargewicht 60 000 und der Säurezahl 94,
0,1 Gt 9-Phenyl-acridin,
0,2 Gt 1,6-Di-hydroxyäthoxy-hexan,
0,02 Gt Supranolblau-GL (C. I. 50335),
13,0 Gt Äthylenglykolmonoäthyläther

hergestellt und auf elektrolytisch aufgerauhtes und anodisiertes 0,3 mm starkes Aluminium aufgeschleudert und wie in Beispiel 1 mit einer Deckschicht versehen. Belichtung, Entwicklung und Beurteilung erfolgten wie in Beispiel 1. Die Anzahl der maximal geschwärzten Keilstufen betrug 4.

Beispiel 7

In diesem Beispiel wurde ein Vergleich zwischen dem Monomeren Verbindung 2 und Trimethyloläthantriacrylat durchgeführt :

Lösung A

11,7 Gt Bindemittellosüng wie in Beispiel 1,
3,9 Gt Verbindung 2,
0,07 Gt-9-Phenyl-acridin,
0,07 Gt 4-Dimethylamino-4'-methyl-dibenzalaceton,
0,04 Gt Farbstoff wie in Beispiel 1 beschrieben,
38,0 Äthylenglykolmonoäthyläther,
13,5 Gt Butylacetat.

Lösung B

11,7 Gt Bindemittellösung wie in Beispiel 1,
3,9 Gt Trimethyloläthantriacrylat,
0,07 Gt 9-Phenyl-acridin,
0,07 Gt 4-Dimethylamino-4'-methyl-dibenzalaceton,
0,04 Gt Farbstoff wie in Beispiel 1,
38,0 Gt Äthylenglykolmonoäthyläther,
13,5 Gt Butylacetat.

Beide Lösungen wurden unter gleichen Bedingungen auf elektrolytisch aufgerauhtes und anodisiertes 0,3 mm starkes Aluminium aufgeschleudert und wie in Beispiel 1 mit einer Deckschicht versehen. Belichtung, Entwicklung und Beurteilung erfolgten wie im Beispiel 1. Bei 30 Sekunden Belichtung betrug die Anzahl der maximal geschwärzten Keilstufen für Lösung A 6, für Lösung B 4.

Beispiel 8

Zur Herstellung von Farbprüffolien wurden vier Beschichtungslösungen entsprechend Beispiel 2 mit der Verbindung 26 und 0,05 Gt 9-Phenyl-acridin als Initiator bereitet und jeweils mit einem der nachstehend aufgeführten Farbstoffe versetzt :

a) Gelbfolie : 0,04 Gt Fettgelb 3 G (C. I. 12700)
b) Rotfolie : 0,02 Gt Zaponechtrot(R) BE (C. I. 12715) und 0,02 Gt Zaponechtrot BB (C. I. Solvent Red. 71)
c) Blaufolie : 0,02 Gt Zaponechtblau(R) HFL (C. I. 74350)
d) Schwarzfolie : 0,04 Gt Fettschwarz HB (C. I. 26150).

Diese Lösungen wurden auf 180 µm dicke, biaxial verstreckte Polyesterfolien aufgeschleudert und bei 100 °C zwei Minuten getrocknet. Dann wurden die Schichten mit einem 1-2 µm dicken Überzug von Polyvinylalkohol Versehen und unter den entsprechenden Silberfilmfarbauszügen wie in Beispiel 1 (Blaufolie 1 Minute, Rotfolie 2 Minuten, Gelb- und Schwarzfolie je 5 Minuten) belichtet. Die Entwicklung erfolgte wie in Beispiel 1.

Beim Übereinanderlegen der Farbprüffolien entstand ein dem Original entsprechendes farbengetreues Duplikat.

Beispiel 9

Eine Beschichtungslösung wurde aus

2,9 Gt Verbindung 2,
4,9 Gt eines Methylmethacrylat/Methacrylsäure Mischpolymerisats mit dem mittleren Molekulargewicht 40 000 und der Säurezahl 125,
0,3 Gt 9-Phenyl-acridin,
10,0 Gt Methyläthylketon,

bereitet, auf 0,3 mm starkes Aluminiumblech gegossen, dessen Ränder im Winkel von 90 °C umgebogen sind, und das Lösungsmittel langsam durch Stehenlassen verdunstet. Anschließend wurde eine Stunde bei 100 °C nachgetrocknet. Die 0,6 mm dicke Photopolymerschicht wurde dann unter einer photographischen Negativvorlage 20 Minuten mit einer Drei-Phasen-Kohlenbogenlampe von 60 A im Abstand von 110 cm belichtet und mit dem in Beispiel 1 beschriebenen Entwickler 15 Minuten im Schaukelbad entwickelt.

Es wurde ein fest haftendes hellgelb getöntes Reliefbild erhalten, das nach dem Entfernen der Ränder für den Hochdruck bzw. « Letterset-Druck » eingesetzt werden kann.

Beispiel 10

Auf den in Beispiel 1 angegebenen Schichtträger wurde eine Lösung folgender Zusammensetzung so aufgeschleudert, daß ein Schichtgewicht von 3,5 g/m$^2$ erhalten wurde :

2,6 Gt der Verbindung 2,
6,5 Gt eines Styrol-Maleinsäureester-Mischpolymerisats mit einer Säurezahl von 145-160 und einem Erweichungspunkt von 140-160 °C,
70,0 Gt Äthylenglykolmonomethyläther,
0,1 Gt 9-Phenyl-acridin,
0,035 Gt des in Beispiel 1 angegebenen Azofarbstoffs und
1,0 Gt des Umsetzungsproduktes aus 1 Mol 2,2,4-Trimethyl-hexamethylendiisocyanat und 2 Mol 2-Hydroxy-äthylmethacrylat.

Die beschichtete Platte wurde anschließend 2 Minuten bei 100 °C im Umlufttrockenschrank getrocknet und mit einer Deckschicht wie in Beispiel 1 versehen. An einem Laserite(R)-Gerät-150 R der Firma Eocom Corp. wurde die Platte mit 200 mW und 1 200 L/inch = 5,3 mJ/cm$^2$ bestrahlt. Der Bildkontrast nach der Bestrahlung ist gut. Anschliessend wurde die Platte mit dem Entwickler von Beispiel 1 entwickelt.

Andruck und Auflagendruck wurden in einer Heidelberger Offsetdruckmaschine GTO mit Dahlgren-Feuchtwerk durchgeführt und betrugen 150 000 Bogen.

**Ansprüche**

1. Durch Strahlung polymerisierbares Gemisch, das
a) eine radikalisch polymerisierbare Verbindung mit endständigen äthylenisch ungesättigten Gruppen,
b) ein polymeres Bindemittel und
c) einen durch Strahlung aktivierbaren Polymerisationsinitiator

enthält, dadurch gekennzeichnet, daß es als polymerisierbare Verbindung eine Verbindung der Formel I

$$\begin{array}{ccccccccc} & & CH_2 & & & & CH_2 & & \\ & & \| & & & & \| & & \\ A & - & C & - & R_1 & - & C & - & A \end{array} \qquad (I)$$

enthält, in der

$R_1$ eine Alkylengruppe mit 1 bis 15 Kohlenstoffatomen, die auch teilweise durch Heteroatome ersetzt sein können, eine Cycloalkylengruppe mit 3 bis 15 Kohlenstoffatomen, oder eine gemischt aliphatischaromatische Kohlenwasserstoffgruppe mit 7 bis 15 Koheinstoffatomen und

A ein elektronenanziehender Rest ist.

2. Durch Strahlung polymerisierbares Gemisch nach Anspruch 1, dadurch gekennzeichnet, daß es eine Verbindung der Formel I enthält, worin

A ein über ein Kohlenstoff- oder Stickstoffatom gebundener Rest ist, in dem dieses Atom an mindestens ein Heteroatom, das O, N oder S sein kann, gebunden ist.

3. Durch Strahlung polymerisierbares Gemisch nach Anspruch 1, dadurch gekennzeichnet, daß es eine Verbindung der Formel II

$$A_1-\underset{\underset{O}{\|}}{C}-\overset{\overset{CH_2}{\|}}{C}-R_1-\overset{\overset{CH_2}{\|}}{C}-\underset{\underset{O}{\|}}{C}-A_1 \qquad \text{(II)}$$

enthält, worin

$A_1$ ein Wasserstoffatom, eine Alkyl-, Aryl-, Hydroxy-, Amino-, Alkoxy-, Aryloxy-, Alkylamino-, Arylamino-, Alkylthio-, Arylthio-, Acyloxy-, Acylamino-, Sulfonyloxy- oder Sulfonylaminogruppe bedeutet und $R_1$ die in Anspruch 1 angegebene Bedeutung hat.

4. Durch Strahlung polymerisierbares Gemisch nach Anspruch 1, dadurch gekennzeichnet, daß es eine Verbindung der Formel III

$$R_2O-\underset{\underset{O}{\|}}{C}-\overset{\overset{CH_2}{\|}}{C}-R_1-\overset{\overset{CH_2}{\|}}{C}-\underset{\underset{O}{\|}}{C}-OR_2 \qquad \text{(III)}$$

enthält, in der

$R_2$ ein Alkyl- oder Alkenylrest mit 1 bis 15 C-Atomen, die auch teilweise durch Heteroatome ersetzt sein können, ein Cycloalkylrest mit 3 bis 15 Kohlenstoffatomen oder ein Aralkylrest mit 7 bis 15 Kohlenstoffatomen

ist und $R_1$ die in Anspruch 1 angegebene Bedeutung hat.

5. Durch Strahlung polymerisierbares Gemisch nach Anspruch 1, dadurch gekennzeichnet, daß es eine Verbindung der Formel I enthält, worin $R_1$ eine Alkylengruppe mit 1 bis 5 Kohlenstoffatomen ist.

6. Durch Strahlung polymerisierbares Gemisch nach Anspruch 1, dadurch gekennzeichnet, daß es eine Verbindung der Formel I enthält, worin A der Rest CN ist.

7. Durch Strahlung polymerisierbares Gemisch nach Anspruch 3, dadurch gekennzeichnet, daß es eine Verbindung der Formel II enthält, worin $A_1$ eine Alkylgruppe mit 1 bis 2 Kohlenstoffatomen ist.

8. Durch Strahlung polymerisierbares Gemisch nach Anspruch 3, dadurch gekennzeichnet, daß es eine Verbindung der Formel II enthält, worin $A_1$ ein Wasserstoffatom ist.

9. Durch Strahlung polymerisierbares Gemisch nach Anspruch 4, dadurch gekennzeichnet, daß es eine Verbindung der Formel III enthält, worin $R_2$ eine Alkylgruppe mit 1 bis 4 Kohlenstoffatomen ist.

10. Strahlungsempflindliches Kopiermaterial aus einem Schichtträger und einer durch Strahlung polymerisierbaren Schicht, die

a) eine radikalisch polymerisierbare Verbindung mit endständigen äthylenisch ungesättigten Gruppen,

b) ein polymeres Bindemittel und

c) einen durch Strahlung aktivierbaren Polymerisationsinitiator

enthält, dadurch gekennzeichnet, daß die Schicht als polymerisierbare Verbindung eine Verbindung der Formel I

$$A-\overset{\overset{CH_2}{\|}}{C}-R_1-\overset{\overset{CH_2}{\|}}{C}-A \qquad \text{(I)}$$

enthält, in der

$R_1$ eine Alkylengruppe mit 1 bis 15 Kohlenstoffatomen, die auch teilweise durch Heteroatome ersetzt sein können, eine Cycloalkylengruppe mit 3 bis 15 Kohlenstoffatomen, oder eine gemischt aliphatischaromatische Kohlenwasserstoffgruppe mit 7 bis 15 Kohlenstoffatomen und

A ein elektronenanziehender Rest ist.

**Claims**

1. A mixture which is polymerizable by radiation and contains

a) a compound which is polymerizable by a free-radical mechanism and has terminal ethylenically unsaturated groups,

b) a polymeric binder and

c) a polymerization initiator which can be activated by radiation,

characterized in that it comprises, as the polymerizable compound, a compound of the formula I

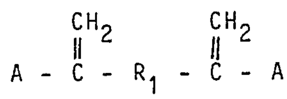

(I)

in which

$R_1$ is an alkylene group having 1 to 15 carbon atoms which can also be partially replaced by heteroatoms, a cycloalkylene group having 3 to 15 carbon atoms, or a mixed aliphatic-aromatic hydrocarbon group having 7 to 15 carbon atoms and

A is an electron-attracting radical.

2. A mixture which is polymerizable by radiation, as claimed in claim 1, characterized in that it comprises a compound of the formula I, in wich

A is a radical which is bonded via a carbon atom or nitrogen atom and in wich this atom is bonded to at least one hetero-atom which can be O, N or S.

3. A mixture which can be polymerized by radiation, as claimed in claim 1, characterized in that it comprises a compound of the formula II

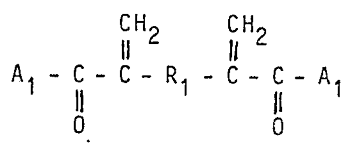

(II)

in which

$A_1$ denotes a hydrogen atom or an alkyl, aryl, hydroxyl, amino, alkoxy, aryloxy, alkylamino, arylamino, alkylthio, arylthio, acyloxy, acylamino, sulfonyloxy or sulfonylamino group and

$R_1$ has the meaning given in claim 1.

4. A mixture which is polymerizable by radiation, as claimed in claim 1, characterized in that it comprises a compound of the formula III

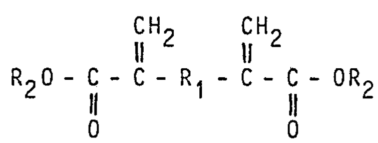

(III)

in wich

$R_2$ is an alkyl or alkenyl radical having 1 to 15 C atoms which can also be partially replaced by heteroatoms, a cycloalkyl radical having 3 to 15 carbon atoms or an aralkyl radical having 7 to 15 carbon atoms and $R_1$ has the meaning given in claim 1.

5. A mixture which is polymerizable by radiation, as claimed in claim 1, characterized in that it comprises a compound of the formula I, in which $R_1$ is an alkylene group having 1 to 5 carbon atoms.

6. A mixture which is polymerizable by radiation, as claimed in claim 1, characterized in that it comprises a compound of the formula I, in which A is the CN radical.

7. A mixture which is polymerizable by radiation, as claimed in claim 3, characterized in that it comprises a compound of the formula II, in which $A_1$ is an alkyl group having 1 to 2 carbon atoms.

8. A mixture which is polymerizable by radiation, as claimed in claim 3, characterized in that it comprises a compound of the formula II, in which $A_1$ is a hydrogen atom.

9. A mixture which is polymerizable by radiation, as claimed in claim 4, characterized in that it comprises a compound of the formula III, in which $R_2$ is an alkyl group having 1 to 4 carbon atoms.

10. A radiation-sensitive reproduction material, comprising a support and a layer which is polymerizable by radiation and contains

a) a compound which is polymerizable by a free-radical mechanism and has terminal ethylenically unsaturated groups,

b) a polymeric binder and

c) a polymerization initiator which can be activated by radiation,

characterized in that the layer contains, as the polymerizable compound, a compound of the formula I

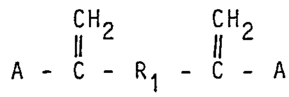

in which

$R_1$ is an alkylene group having 1 to 15 carbon atoms which can also be partially replaced by heteroatoms, a cycloalkylene group having 3 to 15 carbon atoms, or a mixed aliphatic-aromatic hydrocarbon group having 7 to 15 carbon atoms and

A is an electron-attracting radical.

**Revendications**

1. Mélange polymérisable par irradiation, qui contient :

a) un composé polymérisable par un mécanisme radicalaire, ayant des groupes terminaux à insaturation éthylénique,

b) un liant polymère et

c) un initiateur de polymérisation activable par irradiation, lequel mélange étant caractérisé en ce que comme composé polymérisable il contient un composé de formule I

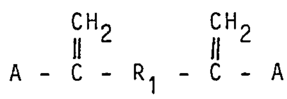 (I)

dans laquelle

$R^1$ est un groupe alcoylène ayant de 1 à 15 atomes de carbone, qui peuvent être également partiellement remplacés par des hétéroatomes, un groupe cycloalcoylène ayant de 3 à 15 atomes de carbone ou un groupe hydrocarboné mixte aliphatique-aromatique ayant de 7 à 15 atomes de carbone et

A est un radical attracteur d'électrons.

2. Mélange polymérisable par irradiation selon la revendication 1, caractérisé en ce qu'il contient un composé de formule 1 dans lequel

A est un radical lié par un atome de carbone ou d'azote, dans lequel cet atome est lié à au moins un hétéroatome qui peut être O, N ou S.

3. Mélange polymérisable par irradiation selon la revendication 1, caractérisé en ce qu'il contient un composé de formule II

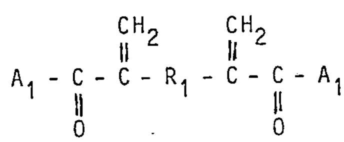 (II)

dans laquelle

$A_1$ représente un atome d'hydrogène, un groupe alcoyle, aryle, hydroxy, amino, alcoxy, aryloxy, alcoylamino, arylamino, alcoylthio, arylthio, acyloxy, acylamino, sulfonyloxy ou sulfonylamino, et

$R_1$ a la signification indiquée dans la revendication 1.

4. Mélange polymérisable par irradiation selon la revendication 1, caractérisé en ce qu'il contient un composé de formule III

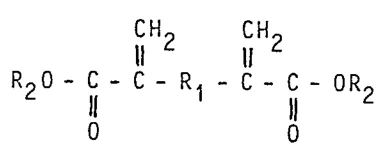 (III)

dans laquelle

$R_2$ est un groupe alcoyle ou alcényle ayant de 1 à 15 atomes de carbone qui peuvent être également partiellement remplacé par des hétéroatomes, un groupe cycloalcoyle ayant de 3 à 15 atomes de carbone ou un groupe aralcoyle ayant de 7 à 15 atomes de carbone et

$R_1$ a la signification indiquée dans la revendication 1.

5. Mélange polymérisable par irradiation selon la revendication 1, caractérisé en ce qu'il contient un composé de formule I, dans lequel $R_1$ est un groupe alcoylène ayant de 1 à 5 atomes de carbone.

6. Mélange polymérisable par irradiation selon la revendication 1, caractérisé en ce qu'il contient un composé de formule I, dans lequel A est le groupe CN.

7. Mélange polymérisable par irradiation selon la revendication 3, caractérisé en ce qu'il contient un composé de formule II, dans lequel $A_1$ est un groupe alcoyle ayant 1 ou 2 atomes de carbone.

8. Mélange polymérisable par irradiation selon la revendication 3, caractérisé en ce qu'il contient un composé de formule II, dans lequel $A_1$ est un atome d'hydrogène.

9. Mélange polymérisable par irradiation selon la revendication 4, caractérisé en ce qu'il contient un composé de formule III, dans lequel $R_2$ est un groupe alcoyle ayant de 1 à 4 atomes de carbone.

10. Matériau de reproduction sensible aux irradiations, composé d'un support et d'une couche polymérisable par radiation, qui contient

a) un composé polymérisable par un mécanisme radicalaire ayant des groupes terminaux à insaturation éthylénique,

b) un liant polymère et

c) un initiateur de polymérisation activable par irradiation, lequel matériau étant caractérisé en ce que la couche contient comme composé polymérisable un composé de formule I

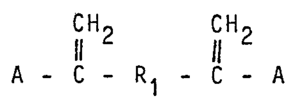

(I)

dans laquelle

$R_1$ est un groupe alcoylène ayant de 1 à 15 atomes de carbone, qui peuvent être également remplacés partiellement par des hétéroatomes, un groupe cycloalcoylène ayant de 3 à 15 atomes de carbone ou un groupe hydrocarboné mixte aliphatique-aromatique ayant de 7 à 15 atomes de carbone et

A est un radical attracteur d'électrons.